# EUROPEAN PATENT APPLICATION

(11) **EP 2 613 373 A2**
(43) Date of publication of application: **10.07.2013**
(21) Application number: 12167044.2
(22) Date of filing: 08.05.2012
(51) Int. Cl.: H01L 33/64

(54) **Light emitting device**

(30) Priority: 04.01.2012 KR 20120001072
(71) Applicant: Samsung Electronics Co., Ltd., Suwon-si, Gyeonggi-do, 443-742 (KR)
(72) Inventor: Lee, Ki Un, 443-470 Gyeonggi-do (KR); Lee, Chang Sub, 135-270 Seoul (KR); Yoon, Sang Ho, 448-533 Gyeonggi-do (KR)
(74) Representative: Grünecker, Kinkeldey, Stockmair & Schwanhäusser

(57) **Abstract**

A light emitting diode (LED) device is provided, which includes at least one LED unit (10) including at least one LED to emit light, a support unit (21) to support the at least one LED unit, and a heat radiation unit (30) disposed between and in contact with the at least one LED unit and the support unit to transmit and radiate heat generated from the at least one LED unit toward the support unit. Accordingly, a dedicated structure for forming contact with air is unnecessary. Therefore, while securing a light emission function, flexible design and aesthetic appearance of the LED device may be achieved.

## Description

### CROSS-REFERENCE TO RELATED APPLICATION

This application claims the benefit of Korean Patent Application No. 10-2012-0001072, filed on January 4, 2012, in the Korean Intellectual Property Office, the disclosure of which is incorporated herein by reference.

### BACKGROUND

### 1. Field of the Invention

The present invention relates to a light emitting diode (LED) device improved in heat radiation efficiency, and more particularly, to an LED device increasing heat radiation efficiency by radiating heat generated from an LED through heat conduction, and providing a slimmed lighting device.

### 2. Description of the Related Art

With recent developments in semiconductor technology, a high-efficiency light emitting diode (LED) is becoming more widely distributed. The LED is applied to a backlight unit of a display device or other various fields such as an incandescent bulb, a fluorescent lamp, or a street lamp.

Since the LED has a relatively long life and consumes a relatively low amount of power, costs for maintenance and repair may be reduced. However, since the LED is subject to a thermal stress, a heat radiation member, such as a heat sink, is necessary. An LED device employing the LED may be limited in design due to the heat radiation member being present. Accordingly, research is underway to improve both heat radiation efficiency and aesthetic appearance.

### SUMMARY

An aspect of the present invention provides a light emitting diode (LED) device improved in heat radiation efficiency and aesthetic appearance simultaneously.

According to an aspect of the present invention, there is provided a light emitting diode (LED) device including at least one LED unit to emit light; a support unit to support the at least one LED unit; and a heat radiation unit to transmit and radiate heat generated from the at least one LED unit toward the support unit through heat conduction.

The at least one LED unit may include a substrate on which a plurality of LEDs are mounted separately from one another, and the heat radiation unit may radiate the heat of the plurality of LEDs by conducting the heat to the support unit through surface contact between the substrate and the support unit.

The heat radiation unit may include a heat radiation plate being in surface contact with the at least one LED unit and the support unit.

The at least one LED unit may be plural in number, and the heat radiation unit may be plural in number to independently contact the plurality of LED units.

The at least one LED unit may be plural in number, and the heat radiation unit may be singular in number to simultaneously contact the plurality of LEDs.

The at least one LED unit may include a plurality of LEDs mounted on the substrate in multiple rows, separately from one another, and the plurality of LEDs may be mounted on the substrate in a zigzagged manner, such that LEDs in neighboring rows are disposed in an alternating pattern.

The heat radiation unit may include a heat radiation plate disposed between the at least one LED unit and the support unit, and the heat radiation plate may include a plurality of guide holes, provided corresponding to a guide projection formed at the support unit, to guide mounting of to the heat radiation plate with respect to the support unit, wherein a portion of the plurality of guide holes is recessed in a U-shape from a side edge toward a center of the heat radiation unit.

The portion of the plurality of guide holes recessed in the U-shape may guide insertion of the guide projection in a direction toward a surface of the heat radiation plate.

The portion of the plurality of guide holes recessed in the U-shape may be disposed at one edge of the heat radiation plate.

The portion of the plurality of guide holes recessed in the U-shape and remaining guide holes may be disposed at opposite edges of the heat radiation plate, respectively.

According to another aspect of the present invention, there is provided an LED device including at least one LED unit to emit light by including at least one LED; a support unit to support the at least one LED unit; and a heat radiation unit disposed between and in contact with the at least one LED unit and the support unit to transmit and radiate heat generated from the at least one LED unit toward the support unit.

The at least one LED may be plural in number and mounted on a substrate, and the heat radiation unit may radiate the heat of the at least one LED unit toward the support unit through surface contact between the substrate and the support unit.

The at least one of LED may be plural in number, and the heat radiation unit is singular in number to simultaneously contact the plurality of LEDs.

The at least one LEDs may be plural in number and mounted on a substrate in multiple rows separately from one another, and the plurality of LEDs may be arranged in a zigzagged manner such that LEDs in neighboring rows are disposed in an alternating pattern.

The heat radiation unit may include a heat radiation plate disposed between the at least one LED unit and the support unit, and the heat radiation plate may include a plurality of guide holes provided corresponding to a guide projection formed at the support unit, to guide mounting of to the heat radiation plate with respect to the support unit, wherein a portion of the plurality of guide holes is recessed in a U-shape from a side edge toward a center of the heat radiation unit.

The portion of the plurality of guide holes recessed in the U-shape may guide insertion of the guide projection in a direction toward a surface of the heat radiation plate.

### BRIEF DESCRIPTION OF THE DRAWINGS

These and/or other aspects, features, and advantages of the invention will become apparent and more readily appreciated from the following description of exemplary embodiments, taken in conjunction with the accompanying drawings of which:
FIG. 1 is a perspective view of a light emitting diode (LED) device according to an embodiment of the present invention;
FIG. 2 is an exploded perspective view illustrating of an LED unit and a support unit shown in FIG. 1;
FIG. 3A is a diagram illustrating heat distribution in the LED unit shown in FIG. 1;
FIG. 3B is a diagram illustrating heat distribution in a general LED unit for comparison to the heat distribution shown in FIG. 3A;
FIG. 4 is a sectional view illustrating the LED device shown in FIG. 1;
FIG. 5 is a graph illustrating relationships between a temperature and a thickness of a heat radiation unit according to an embodiment of the present invention;
FIG. 6 is a graph illustrating relationships between a radiation temperature and power consumption of an LED device according to thicknesses of a heat radiation unit, according to an embodiment of the present invention;
FIG. 7 is a graph illustrating relationships between a radiation temperature and a thickness of a heat radiation unit according to power consumption of an LED device, according to an embodiment of the present invention;
FIG. 8 is a graph illustrating an explanation of an equation related to a distance among a plurality of LEDs generated by a heat radiation unit, according to an embodiment of the present invention;
FIG. 9 is a graph illustrating an explanation of an equation related to an increase in power consumption of a plurality of LEDs arranged in uniform distances; and
FIG. 10 is a sectional view illustrating an LED device according to another embodiment of the present invention.

### DETAILED DESCRIPTION

Reference will now be made in detail to exemplary embodiments of the present invention, examples of which are illustrated in the accompanying drawings, wherein like reference numerals refer to the like elements throughout. Exemplary embodiments are described below to explain the present invention by referring to the figures.

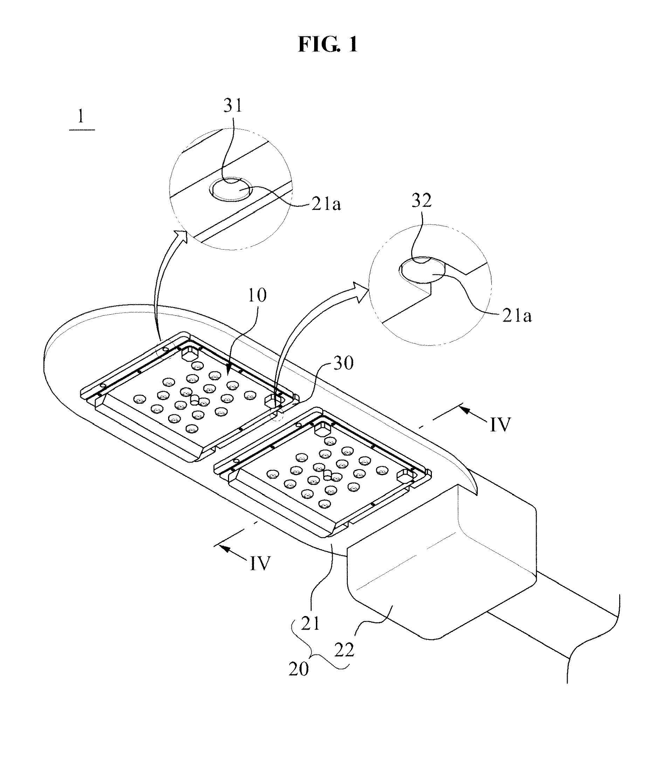

Referring to FIG. 1, a light emitting diode (LED) device 1 according to embodiments of the present invention includes an LED unit 10, a support unit 20, and a heat radiation unit 30. The LED device 1 according to the present embodiment will be explained as a lighting device such as a street lamp. However, the present invention is not limited to the embodiment.

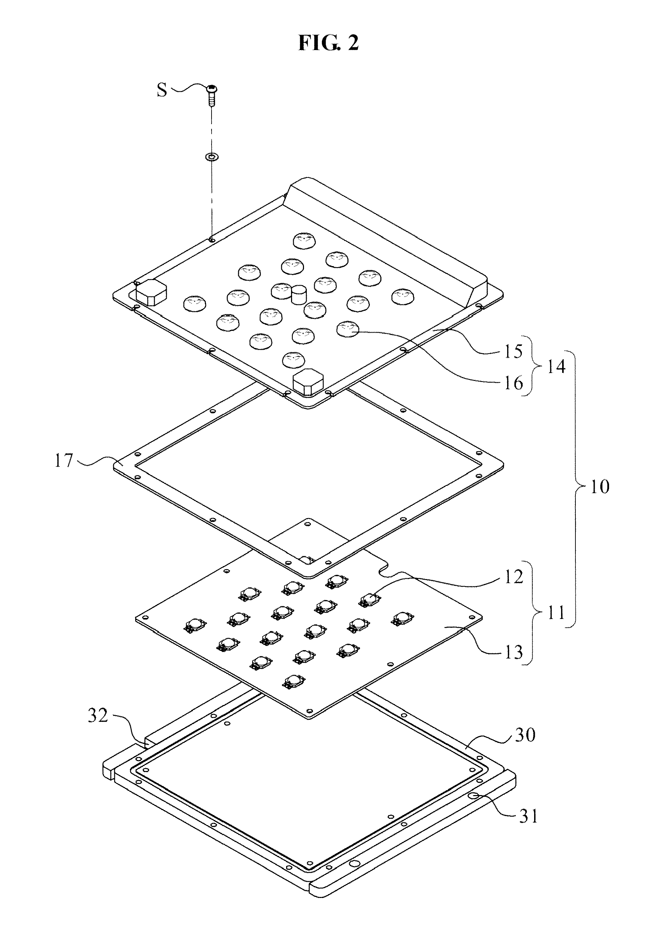

The LED unit 10 as a light source of the LED device 1 may include at least one LED 12 as shown in FIG. 2. The LED unit 10 may include an LED portion 11 and a cover portion 14.

The LED portion 11 may include at least one LED 12, and a substrate 13 for mounting the at least one LED 12. The at least one LED 12 may include a general light emitting diode. The substrate 13 may include a printed circuit board printed with a predetermined pattern for controlling the at least one LED 12. However, the at least one LED 12 may be any one of various light emitting means, and is not limited to the general light emitting diode. In addition, the substrate 13 may be any one selected from various control units, such as a lead frame, which is electrically connected to the at least one LED 12 to control light emission operation.

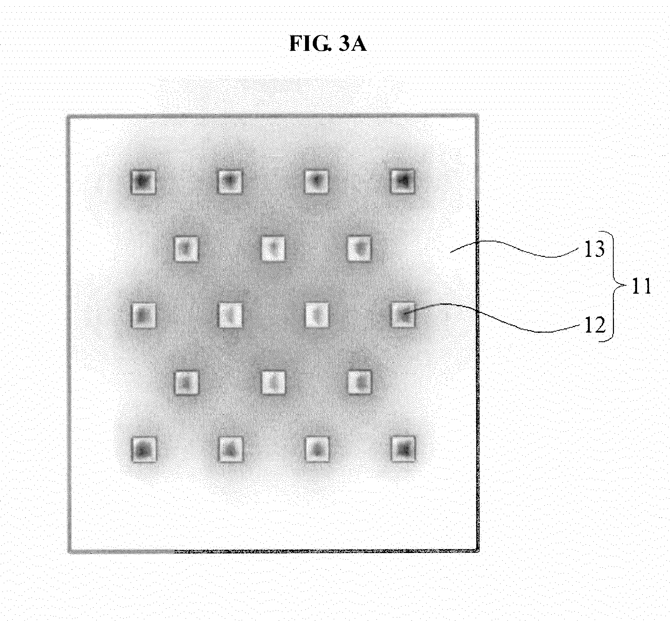

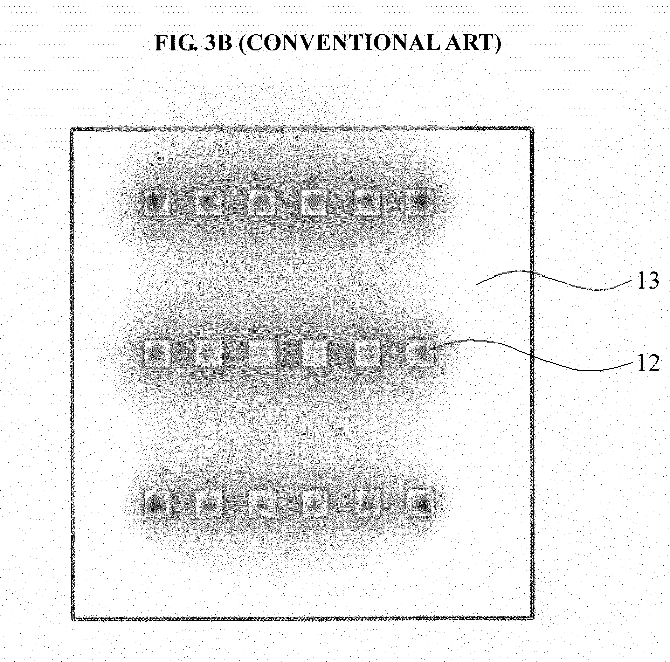

The at least one LED 12 may be plural in number. The plurality of LEDs 12 may be mounted on the substrate 13 in multiple rows, separately from one another. The plurality of LEDs may be mounted on the substrate 13 in a zigzagged manner such that LEDs in neighboring rows are disposed in an alternating pattern. Therefore, heat generated from the plurality of LEDs 12 may be evenly distributed as shown in FIG. 3A without being concentrated on a certain area as shown in FIG. 3B.

Although the plurality of LEDs 12 are illustrated as being mounted in the zigzagged manner, the plurality of LEDs 12 may be mounted on the substrate 13 in various other patterns, such as a radial pattern, in which the plurality of LEDs 12 are separated so as not to be concentrated to a particular area so that concentration of heat generated during the light emission is prevented.

As shown in FIG. 2, the cover portion 14 may include a cover plate 15 corresponding to the substrate 13, and a plurality of lenses 16 disposed at the cover plate 15 to cover the plurality of LEDs 12, respectively, and to guide a light path. The plurality of lenses 16 may be made of a resin, such as silicone, so as to guide light generated from the plurality of LEDs 12 in a predetermined direction without interfering with the light path.

The cover portion 14 may cover the substrate 13 with a sealing member 17 interposed between the cover portion 14 and the substrate 13, thereby preventing entry of foreign substances. The sealing member 17 may be made of a resilient material, for example rubber, to have not only a sealing function but also a cushioning function against external forces.

In FIG. 1, the LED unit 10 including the LED portion 11 and the cover portion 14 are two in number. However, the number of LED units is not limited to two. A single LED unit 10 or more than three LED units 10 may be provided according to an environment and conditions for lighting.

As shown in FIG. 1, the support unit 20 supports the LED unit 10. For this purpose, the support unit 20 may include a support plate 21 to support a rear side of the substrate 13 with respect to a direction of light emission from the plurality of LEDs 12, and a supporter 22 to fix the support plate 21. One end of the support plate 21 may be inserted and fixed in the supporter 22 by a predetermined length.

Although not shown in detail, the supporter 22 may be extended by a predetermined length as when applied to a street lamp or a desk lighting device and support the LED 10 in a direction to emit light.

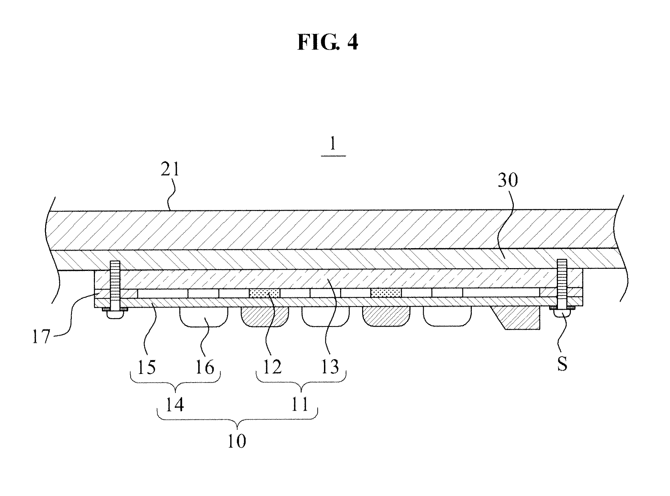

The heat radiation unit 30 may be disposed between the LED unit 10 and the support unit 20 as shown in FIGS. 1 and 4, and radiate heat of the LED unit 10 toward the support unit 20 through heat conduction. As shown in FIG. 2, the heat radiation unit 30 may be provided in a plate shape for surface contact with the substrate 13. That is, the heat radiation unit 30 may include a heat radiation plate for surface contact with the substrate 13. Here, the heat radiation unit 30 provided in the plate shape may have a shape and size corresponding to the substrate 13 and may be plural in number in order to correspond to a plurality of the substrate 13.

Since the substrate 13 of the LED unit 10 is illustrated to be in a rectangular plate shape in FIG. 2, the heat radiation unit 30 will also be illustrated to be in a rectangular plate shape. However, when the LED unit 10 is a circular plate shape, the heat radiation unit 30 may accordingly have the circular plate shape. In addition, although the substrate 13 of the LED unit 10 is in the circular plate form, the heat radiation unit 30 may be in a polygonal plate shape for surface contact with the substrate 13.

As shown in FIG. 2, the heat radiation unit 30 may be connected to the LED unit 10 by a predetermined fastening member such as a screw S and fixed to the support plate 21 of the support unit 20. For convenient fixing of the heat radiation unit 30 to the support plate 21, a plurality of guide holes, for example, guide holes 31 and 32 may be formed through the heat radiation unit 30 corresponding to a guide projection 21a formed on the support plate 21 as shown in FIG. 1.

The guide holes 31 and 32 may be divided into a first guide hole 31 disposed at one side edge of the heat radiation unit 30 and formed in a circular shape corresponding to a cross section of the guide projection 21a, and a second guide hole 32 disposed at another side edge opposite to the one side edge of the heat radiation unit 30 and separately from the first guide hole 31. That is, the first guide hole 31 and the second guide hole 32 may be disposed at the facing edges of the heat radiation unit 30.

The second guide hole 32 may be recessed in a U-shape from the side edge toward a center of the heat radiation unit 30, to guide insertion of the guide projection 21a toward a surface of the heat radiation unit 30.

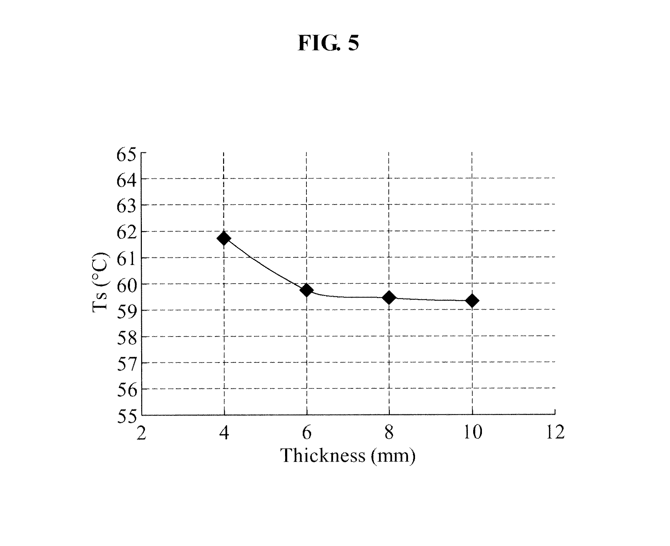

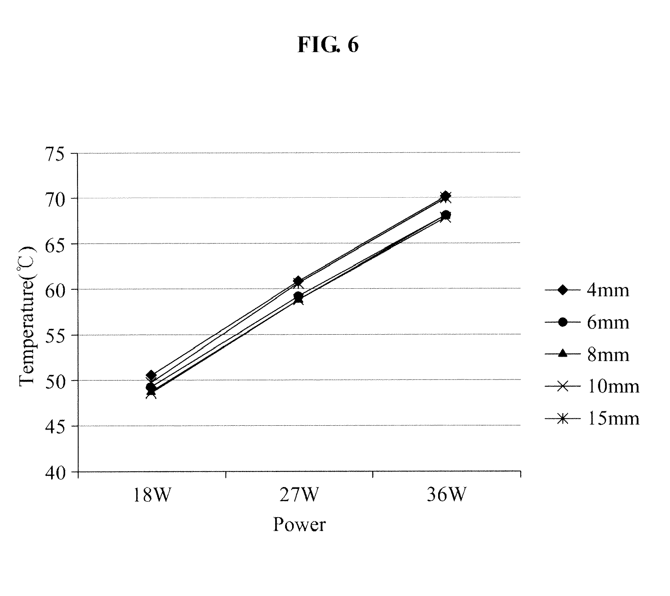

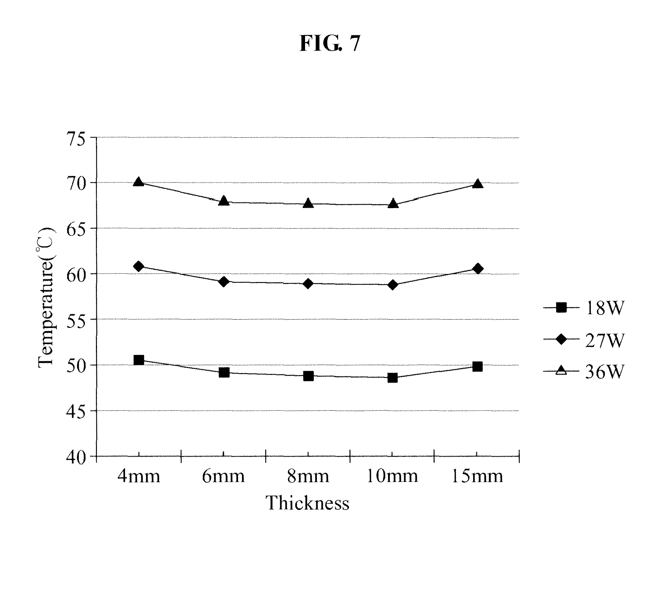

As shown in FIG. 5, the heat radiation unit 30 has almost constant radiation temperatures (°C) when having thickness of about 6 millimeters (mm) or greater. In particular, referring to FIG. 6, when the heat radiation unit 30 has thicknesses of 4 mm, 6 mm, 8 mm, 10 mm, and 15 mm, the radiation temperatures (°C) of the LED device 1 per power consumptions of 18W, 27W, and 36W are similar to one another. Furthermore, referring to FIG. 7, even when the power consumptions (W) of the LED device 1 are varied, the radiation temperatures (°C) according to the thicknesses of the heat radiation unit 30 are almost constant.

Referring to the graphs of FIGS. 5 to 7, the radiation temperature of the heat radiation unit 30 does not unlimitedly increase in proportion to the thickness. When the thickness of the heat radiation unit 30 is about 6 mm or greater, since heat radiation occurs depending on only conduction rather than both conduction and radiation, heat radiation efficiency of the heat radiation unit 30 is substantially reduced. Therefore, the thickness of about 6 mm of the heat radiation unit 30 is efficient in terms of material cost, weight, heat radiation efficiency, and aesthetic appearance.

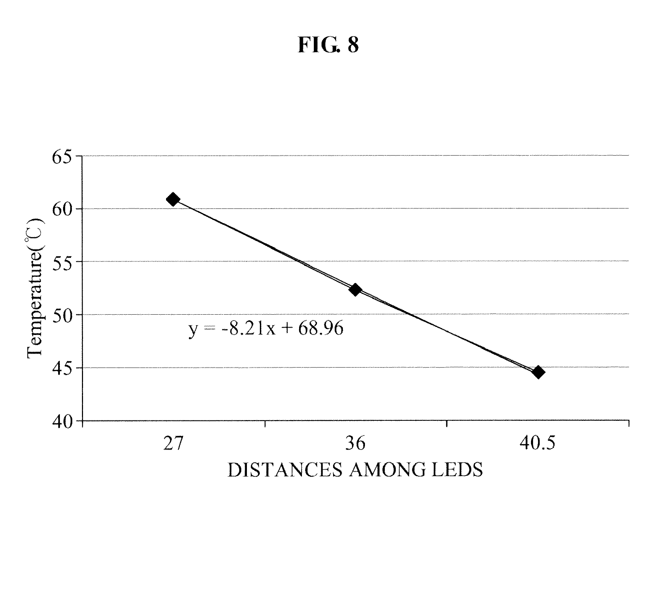

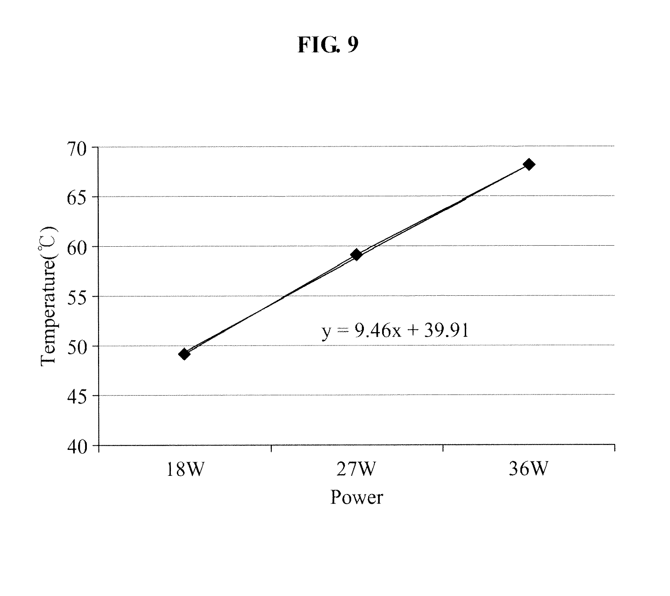

In addition, as shown in FIG. 8, distances among the plurality of the LEDs 12 generated by the heat radiation unit 30 may be expressed by an equation y = -8.21x + 68.96. As shown in FIG. 9, an increase in power consumption of the plurality of LEDs 12 arranged in uniform distances may be expressed by an equation y = 9.46x + 39.91.

For secure heat radiation efficiency, a heat radiation area of the heat radiation unit 30, which contacts the substrate 13, may be at least twice an entire surface area of the substrate 13.

Hereinafter, the heat radiation operation of the LED device 1 according to the embodiment of the present invention will be described with reference to FIGS. 1 to 4.

First, when the LED unit 10 including the plurality of LEDs 12 emits light as shown in FIGS. 1 and 2, heat is generated mainly from the plurality of LEDs 12 mounted on the substrate 13 as shown in FIG. 3A. The heat generated by the light emission operation may be radiated by the heat radiation unit 30 provided in surface contact between the support plate 21 of the support unit and the substrate 13 as shown in FIG. 4. That is, the heat radiation unit 30 may receive the heat through contact with the substrate 13 of the LED unit 10, and conduct the heat to the support plate 21. The support plate 21 may radiate the heat as a radiant heat.

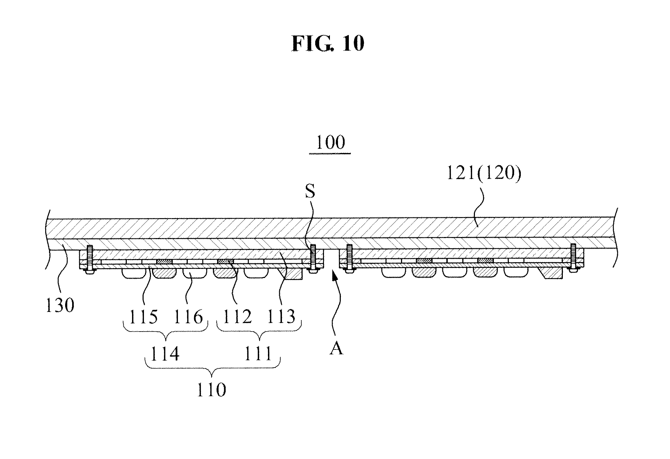

FIG. 10 illustrates an LED device 100 according to another embodiment of the present invention. FIG. 10 is a sectional view of the LED device 100.

Referring to FIG. 10, the LED device 100 according to another embodiment may include an LED unit 110, a support unit 120, and a heat radiation unit 130.

The LED unit 110 may include an LED portion 111 including an LED 112 and a substrate 113, and a cover portion 114 including a cover plate 115 and a lens 116.

The LED unit 110 including the LED portion 111 and the cover portion 114 is structured in almost the same manner as the LED unit 10 of the LED device 1 shown in FIGS. 1 to 5. Therefore, a detailed description about the LED unit 110 will be omitted for conciseness. A plurality of the LED units 110 may be provided depending on the environment and conditions of lighting. The present embodiment will be described as having two LED units 110.

As in the previous embodiment, the support unit 120 is adapted to support the LED unit 110. Although only a support plate 121 is shown in FIG. 10, the support unit 120 includes a supporter (not shown) as in the previous embodiment shown in FIG. 1. Since the support unit 120 has almost the same structure as the support unit 20 of the previous embodiment, a detailed description will be omitted for conciseness.

The heat radiation unit 130 is singular in number and adapted to radiate heat of the plurality of LED units 110 simultaneously. For this purpose, the heat radiation unit 130 may form surface contact with the plurality of LED units 110 simultaneously, and conduct heat of the plurality of LED units 110 to the support plate 121 of the support unit 120. According to an alteration of the heat radiation unit 130, a dedicated cover may be provided to cover a non-radiation area A in FIG. 10 disposed between neighboring LED units 110, so that the non-radiation area A is not exposed forward with respect to a direction of light emission from the plurality of LED units 110.

In the above-structured LED device 100, heat generated from the plurality of LED units 110 may be conducted and radiated to the support unit 120 through the single heat radiation unit 130 being in surface contact with the plurality of LED units 110.

In the foregoing embodiments, the support plates 21 and 121 take the form of a flat plate and the heat radiation units 30 and 130 are mounted to the support plates 21 and 121 in a protruding manner. However, the heat radiation units 30 and 130 may be embedded in the support plates 21 and 121 so that heat is conducted toward the heat radiation units 30 and 130.

Thus, in an LED device according to the embodiments of the present invention, since heat of an LED unit is radiated through heat conduction, a predetermined degree of heat radiation may be secured under various conditions. Accordingly, heat radiation efficiency may be increased.

In addition, since a heat radiation unit radiates heat of the LED unit to a support unit that supports the LED unit, a dedicated structure such as a conventional heat sink for forming contact with air is unnecessary. As a result, the LED device may be slimmed and aesthetically improved.

Furthermore, when the structure for contact with air is omitted, design of the LED device may become more flexible.

Although a few exemplary embodiments of the present invention have been shown and described, the present invention is not limited to the described exemplary embodiments. Instead, it would be appreciated by those skilled in the art that changes may be made to these exemplary embodiments without departing from the principles and spirit of the invention, the scope of which is defined by the claims and their equivalents.

## Claims

1. A light emitting diode (LED) device comprising:
at least one LED unit to emit light;
a support unit to support the at least one LED unit; and
a heat radiation unit to transmit and radiate heat generated from the at least one LED unit toward the support unit through heat conduction.

2. The LED device of claim 1, wherein
the at least one LED unit comprises a substrate on which a plurality of LEDs are mounted separately from one another, and
the heat radiation unit radiates the heat of the plurality of LEDs by conducting the heat to the support unit through surface contact between the substrate and the support unit.

3. The LED device of claim 1, wherein the heat radiation unit comprises a heat radiation plate being in surface contact with the at least one LED unit and the support unit.

4. The LED device of claim 1, wherein
the at least one LED unit is plural in number, and
the heat radiation unit is plural in number to independently contact the plurality of LED units.

5. The LED device of claim 1, wherein
the at least one LED unit is plural in number, and
the heat radiation unit is singular in number to simultaneously contact the plurality of LEDs.

6. The LED device of claim 1, wherein
the at least one LED unit comprises a plurality of LEDs mounted on the substrate in multiple rows separately from one another, and
the plurality of LEDs are mounted on the substrate in a zigzagged manner such that LEDs in neighboring rows are disposed in an alternating pattern.

7. The LED device of claim 1, wherein the heat radiation unit comprises a heat radiation plate disposed between the at least one LED unit and the support unit, and
the heat radiation plate comprises a plurality of guide holes provided corresponding to a guide projection formed at the support unit, to guide mounting of to the heat radiation plate with respect to the support unit, wherein a portion of the plurality of guide holes is recessed in a U-shape from a side edge toward a center of the heat radiation unit.

8. The LED device of claim 7, wherein the portion of the plurality of guide holes is recessed in the U-shape guide insertion of the guide projection in a direction toward a surface of the heat radiation plate.

9. The LED device of claim 7, wherein the portion of the plurality of guide holes recessed in the U-shape is disposed at one edge of the heat radiation plate.

10. The LED device of claim 7, wherein the portion of the plurality of guide holes is recessed in the U-shape and remaining guide holes are disposed at opposite edges of the heat radiation plate, respectively.

11. A light emitting diode (LED) device comprising:
at least one LED unit to emit light by including at least one LED;
a support unit to support the at least one LED unit; and
a heat radiation unit disposed between and in contact with the at least one LED unit and the support unit to transmit and radiate heat generated from the at least one LED unit toward the support unit.

12. The LED device of claim 11, wherein
the at least one LED is plural in number and mounted on a substrate, and
the heat radiation unit radiates the heat of the at least one LED unit toward the support unit through surface contact between the substrate and the support unit.

13. The LED device of claim 11, wherein
the at least one of LED is plural in number, and
the heat radiation unit is singular in number to simultaneously contact the plurality of LEDs.

14. The LED device of claim 11, wherein
the at least one LEDs is provided in plural number and mounted on a substrate in multiple rows separately from one another, and
the plurality of LEDs are arranged in a zigzagged manner such that LEDs in neighboring rows are disposed in an alternating pattern.

15. The LED device of claim 11, wherein
the heat radiation unit comprises a heat radiation plate disposed between the at least one LED unit and the support unit, and
the heat radiation plate comprises a plurality of guide holes provided corresponding to a guide projection formed at the support unit, to guide mounting of to the heat radiation plate with respect to the support unit, wherein a portion of the plurality of guide holes is recessed in a U-shape from a side edge toward a center of the heat radiation unit.

16. The LED device of claim 15, wherein the portion of the plurality of guide holes is recessed in the U-shape guide insertion of the guide projection in a direction toward a surface of the heat radiation plate.
